Europäisches Patentamt

European Patent Office

Office européen des brevets

(11) Publication number : **0 467 698 A2**

# (12) EUROPEAN PATENT APPLICATION

(21) Application number : **91306594.2**

(22) Date of filing : **19.07.91**

(51) Int. Cl.⁵ : **H05K 3/42**

(30) Priority : **20.07.90 US 554848**

(43) Date of publication of application :
**22.01.92 Bulletin 92/04**

(84) Designated Contracting States :
**DE GB NL SE**

(71) Applicant : **NORTHERN TELECOM LIMITED**
**600 de la Gauchetiere Street West**
**Montreal Quebec H3B 4N7 (CA)**

(72) Inventor : **Barnhouse, Robert L.**
**113 Almeria Street**
**Royal Palm Beach, Florida 33444 (US)**
Inventor : **Estes, H. Scott**
**300 N.W. 22nd Street**
**Delray Beach, Florida 33444 (US)**

(74) Representative : **Ryan, John Peter William**
**Northern Telecom Europe Limited Patents and**
**Licensing West Road**
**Harlow Essex CM20 2SH (GB)**

(54) **Printed circuit board having holes with multiple conductors.**

(57) A printed circuit board having holes provided with two or more electrical conductors on the surface of each hole. The conductors are circumferentially spaced apart around each hole so as to electrically isolate them from one another and each conductor is connected to an individual circuit line of the board. The conductors may be through-hole conductors. Alternatively, the holes are pin receiving holes for insertion of pins having two or more conductor lines for electrical contact with the conductors within the holes.

FIG.12

FIG.13

EP 0 467 698 A2

This invention relates to improvements in or relating to printed circuit boards.

Conventionally, printed circuit boards are provided with holes for acceptance of circuit board pins and each circuit board pin communicates with circuitry provided by the circuit board.

At the present time efforts are being made to miniaturise electrical and electronic circuitry and its component parts. While many improvements have been made in this respect, not only with regard to the sizes of solid state chips for performing multiple electronic function, efforts to reduce the size of printed circuit boards have been somewhat frustrated.

Another problem is related to the provision of electrical conductors extending from one side to the other on a board for the purpose of interconnecting together circuits on the two sides. These conductors are hereinafter referred to as "through-hole conductors". Boles are drilled in a board, the holes then being filled with copper by deposition techniques to form the through-hole conductors. These holes, which may be spaced apart by only 0.100 inches, only require to have diameters around 0.013 inches to provide sufficient cross-sectional area for the through-hole conductors for their electrical requirements. However, there are various problems associated with the provision of the small diameter holes, particularly the problem of drill breakage.

The present invention seeks to provide a circuit board which may carry a high concentration of circuitry thereby enabling the size of the board to be minimised while performing its required function. The present invention also seeks to provide a method of providing a circuit board with electrical conductors within holes and which minimises the above problems.

Accordingly, the present invention provides a printed circuit board comprising a substrate defining a plurality of holes and at least two electrical conductors are provided upon the surface of each hole, the conductors being spaced apart from one another circumferentially of each hole so as to be electrically isolated from one another, with each conductor electrically connected to an individual circuit line carried by the substrate and extending towards the hole.

In a circuit board according to the invention, holes provided with two or more electrical conductors may be used for receiving circuit board pins, one pin to each hole. In this case, the electrical conductors of these holes provide electrical terminals for engagement with electrical conductor lines extending longitudinally of the pins. These pins, specifically designed for insertion into their individual holes have a plurality of individual conductor lines which are electrically isolated from one another. Thus, with this construction, spacing of the terminals for each individual circuit line is not determined by the spacing of the holes in the board. In contrast, the density of the terminal positions is determined by the hole spacing and also by the number of terminals provided at each hole. Hence, for a given hole spacing, more terminals are provided in the board for contact with circuit board pins and a denser board circuitry is made possible.

Alternatively, two or more electrical conductors of a hole may be used as through-hole conductors to interconnect circuits together on the two sides of the board. In this case, each hole may be drilled with a substantially large diameter, e.g. approximately that for receiving a circuit board pin (perhaps in the region of o.040 inch diameter), so that the problems associated with drilling small diameter holes around o.013 inches are minimised or overcome. Each through-hole conductor which extends circumferentially for a distance around its hole is easily provided with its required cross-sectional dimensions for electrical requirements by known plating techniques.

Conveniently, each electrical conductor in a hole is provided as an arcuate layer which extends partly around the surface of its hole. In the case where the conductors are to be used as through-hole conductors, then the space within each hole which is unoccupied by the conductor material may be at least partly blocked by a plug of dielectric material.

Each electrical conductor within each hole preferably comprises an electrolessly deposited underlayer and a further layer covering the underlayer. Also, each circuit line, when carried upon one side of the substrate, preferably comprises an underlayer laminated to the substrate and then second and third layers formed, respectively, by electroless deposition and electroplating techniques.

The invention further comprises an assembly of a printed circuit board and a plurality of pins wherein the circuit board defines a plurality of holes and at least two electrical conductors are provided upon the surface of each hole, the conductors being spaced apart from one another circumferentially of each hole so as to be electrically isolated from one another with each conductor extending to an individual circuit path of the board which extends towards the hole, and each circuit board pin has a plurality of electrical conductor lines which extend longitudinally of the pin and are electrically isolated from one another, the pins inserted into individual holes with the circuit lines in electrical contact with individual electrical conductors within the holes.

The invention further includes a method of providing a circuit board with electrical conductors within holes in a substrate of the board couprising providing the substrate with a plurality of holes, and then forming at least two electrical conductors upon the surface of each hole, said electrical conductors spaced apart from one another circumferentially of each hole so as to be electrically isolated from one another.

In an advantageous way of performing the method, a masking plug is inserted into each hole to leave desired exposed regions, spaced circumferentially of the hole and extending along the length of the hole. The exposed regions are then coated with conductor material to provide the electrical conductors. Conductive material may be first applied to cover the whole surface of each hole. The masking plug is then inserted so that some regions of the conductive material are masked and other regions remain exposed. The regions are then coated with an etch resistant electrically conductive substance, e.g. a tin/lead composition, and then the plug is removed and the uncoated conductive material at the previously masked regions are removed by etching. As a result, the conductive material in the other regions together with their coating substance provide the circumferentially extending electrical conductors.

With the above method, the conductive material may be applied by a first application of electroless material to cover the surface of each hole and then electroplating over the whole of this surface before applying the masking plug. However, upon removal of the plug from each hole, the electroplated and electroless conductive material needs to be removed by etching from the uncoated regions. Preferably therefore by electroless coating. a first layer of conductive material is applied to cover the surface of each hole and then the masking plug is inserted into each hole. By electroplating, a second layer of conductive material is applied to the exposed regions of the first layer before the coating of the etch resistant substance is applied. Thus, upon remonal of the plug, there is only the first application of material to be removed in the non-coated regions.

In many practical instances of the use of the method of the invention, a first layer of conductive material is applied into the holes of a substrate which has been previously provided on at least one surface with a conductive layer laminated into the substrate. The first layer then covers the surface of the hole and the laminated conductive layer. In this case, for the purpose of providing conductive mutually isolated circuits upon desired areas of the surface of the substrate, a plating resistive ink screened image mask is applied to other surface areas and the masking plug is then inserted into each hole. A second layer of conductive material is electroplated onto the exposed regions of the first layer within the holes and this second layer as also covers the first application applied to the unscreened areas of the laminated conductive layer on the surface of the substrate. Subsequently the exposed regions within the holes and the unscreened areas on the board surface are coated with the etch resistant substance and after the plug and the screen have been removed, the conductive material unprotected by the etch resistant substance is etched away whereby desired areas of conductors are provided upon the substrate surface and which communicate with the electrical conductors in the holes. Hence, each electrical conductor within the hole is electrically connected to an individual conductor path upon the surface of the board.

Alternatively, a first layer of a conductive material is applied, preferably by an electroless process, to cover the surface of each hole and arcuate circumferentially extending regions of the conductive material are then selectively removed by cutting, e.g. by broaching, routing, milling or laser or water cutting so that desired spaced circumferentially extending regions of the conductive material remain. By an electroplating process, a second layer of the conductive material is applied to the desired spaced regions so as to thicken them and provide the electrical conductors. In a case where the board has been previously provided on at least one surface with a laminated conductive layer, the electroless plated layer of the conductor material also covers the previously provided conductive layer and the electroplated layer covers the electroless plated layer upon the substrate surface in addition to within the holes. The electroplated layer is applied only to areas on the substrate surface in which conductor material is required in the finished board by the use of screening methods on all other surface areas. After an etch resistant electrically conductive substance such as tin/lead compositions has been added to cover the electroplated layer of conductive material, the screen is removed and all uncoated areas on the surface of the board are etched away so that each of the electrical conductors in the holes are connected to individual conductive areas on the outside of the board.

Embodiments of the invention will now be described, by way of example, with reference to the accompanying drawings, in which:-

Figure 1 shows, in a first embodiment, a plan view of part of a substrate at a first stage of forming two electrical conductors upon the surface of a hole in the substrate in the manufacture of a printed circuit board;

Figure 2 is a cross-sectional view through the substrate taken along line II-II in Figure 1;

Figures 3 and 4 are plan views showing two further stages in the formation of the electrical conductors in the first embodiment;

Figure 5 is a cross-sectional view of the partially completed board taken along line V-V in Figure 4 and showing plugs inserted into adjacent holes at the stage of conductor manufacture shown in Figure 4;

Figure 6 is a plan view showing yet a further stage in the manufacture of the conductors in the first embodiment;

Figure 7 is a cross-sectional view of the partially coupleted board taken along line VII-VII in Figure 6;

Figure 8 is a plan view of the partially coupleted board showing yet a further stage in the manufacture of the conductors;

Figure 9 is a cross-sectional view through the partially completed board in Figure 8 taken along line IX-IX in Figure 8;

Figure 10 is a plan view of the partially completed board according to the first embodiment and showing the next stage in the formation of the two electrical conductors;

Figure 11 is a cross-sectional view of the partially completed board taken along line XI-XI in Figure 10;

Figure 12 is a plan view of the completed board showing the final stage in the manufacture of the two electrical conductors;

Figure 13 is a cross-sectional view of the printed circuit board taken along line XIII-XIII in Figure 12;

Figure 14 is an isometric view of a printed circuit board pin for insertion into a hole in the board of the first embodiment;

Figure 15 is an isometric view of a laminated strip showing a stage in the manufacture of the pin of Figure 14 and to a smaller scale than Figure 14;

Figure 16 is a plan view of a coated dielectric strip for making the pin of Figure 14 according to a different process from that associated with Figure 15;

Figure 17 is a cross-sectional view through the strip of Figure 16 and taken along line XVII-XVII in Figure 16;

Figure 18 is a cross-sectional view of part of the circuit board of the first embodiment with the pin of the structure of Figure 14 inserted into a hole in the board;

Figure 19 is a cross-sectional view through a printed circuit board forming a modification of the first embodiment;

Figure 20 is a plan view of the printed circuit board of Figure 19 taken in the direction of arrow XX in Figure 19;

Figures 21, 22 and 23 show three different stages of forming two electrical conductors in a hole in a printed circuit board according to a second embodiment;

Figure 24 is a view similar to Figure 18 and showing the pin of Figure 14 mounted within a hole in the board of the second embodiment;

Figure 25 is a plan view of part of a printed circuit board according to a third embodiment and showing four electrical conductors located within a hole in the board;

Figure 26 is a cross-sectional view through the board showing one stage in the manufacture of the four electrical conductors in a single hole;

Figure 27 is an isometric view of a printed circuit board pin for insertion into a hole in the board of the third embodiment;

Figure 28 is a cross-sectional view of the pin of Figure 27 taken along line XXVIII-XXVIII in Figure 27;

Figures 29 and 30 are cross-sectional views similar to Figure 28 and showing various stages in the manufacture of the circuit board pin of Figure 27;

Figure 31 is a view similar to Figure 18 and showing the pin of Figure 27 mounted within a hole of the board of the third embodiment;

Figures 32 and 33 are cross-sectional views through a printed circuit board according to a fourth embodiment and showing different stages in its manufacture;

Figure 34 is a cross-sectional view through a printed circuit board pin for insertion into a hole in the board of the fourth embodiment; and

Figure 35 is a view similar to Figure 33 and showing the pin of Figure 34 mounted into the board of the fourth embodiment.

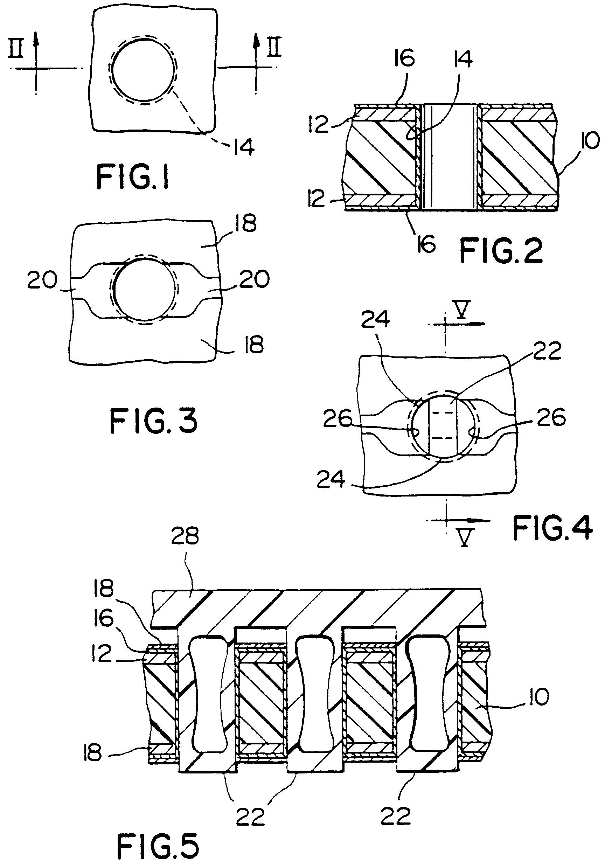

In a first embodiment of the invention, a printed circuit board is to be provided with two electrical conductors upon the surface of each hole in the board. To make the printed circuit board, a conventional fibreglass substrate 10 (see Figure 2) is provided for carrying the circuitry of the board, the substrate having a preformed layer 12 of copper laminated upon each of its surfaces.

By electroless plating techniques, a conductive material, namely copper, is added upon the two layers 12 and into each of the holes 14 in the board so as to provide a covering layer 16 which may be in the region of 0.0001 to 0.0002 inches thick. As can be seen from Figure 2, this layer covers all the exposed surfaces of the layers 12 and of the surfaces of the holes 14. Subsequently as shown by Figure 3, a screen 18 is provided over the two outside planar surfaces of the layer 16 as a conventional plating resistive ink screened image mask so that parts 20 of the layer 16 which overlay the layer 12 and which follow desired conductor paths in the finished board remain exposed.

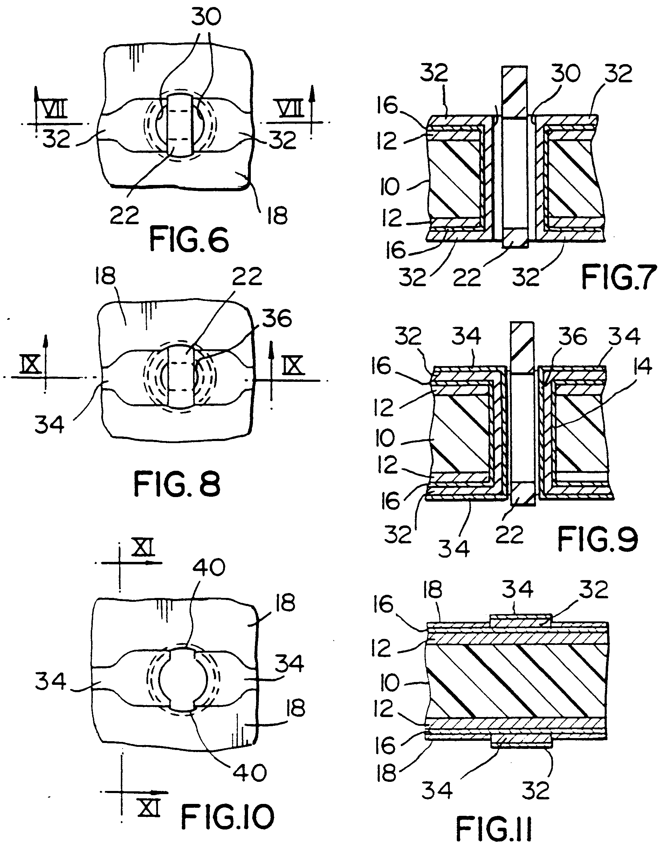

In the next stage, plugs 22 of resilient elastomer are inserted into each of the holes as shown in Figure 4 and 5. The plugs 22 are masking plugs and engage the mask circumferentially extending regions 24 of the layer 16 in each hole so that other circumferentially extending regions 26 of the layer 16 in the holes remain unmasked by the plugs. As may be seen from Figure 4, the circumferentially extending regions 26 are circumferentially spaced apart around each hole by a plug. As seen by figure 5, for convenience during commercial manufacture and with the holes arranged in straight lines, a plurality of the plugs 22 may be molded integrally with a main header 28 so that the plugs for any particular row may be inserted together in a single operation. In a further stage in the manufacture of the two conductors, by electroplating techniques further copper is added to the parts of the layer 16 remaining exposed. This includes the parts 20 on the two sides of the board (Figure 3) and the two circumferentially extending regions 26 in Figure 4. This electroplating operation results in a further layer 30 of copper added to each of the circumferentially extending regions 26 within each hole (Figures 5, 6 and 7) and a further layer 32 upon the layer 16 upon each surface of the board. An etch masking substance is then provided upon the layers 30 and 32, this etch masking substance being a conventional tin/lead mixture to form an overall covering layer 34 extending over the layers 32 and a layer 36 upon the layer 30 within each of the holes 14. This is the stage shown in Figures 8 and 9.

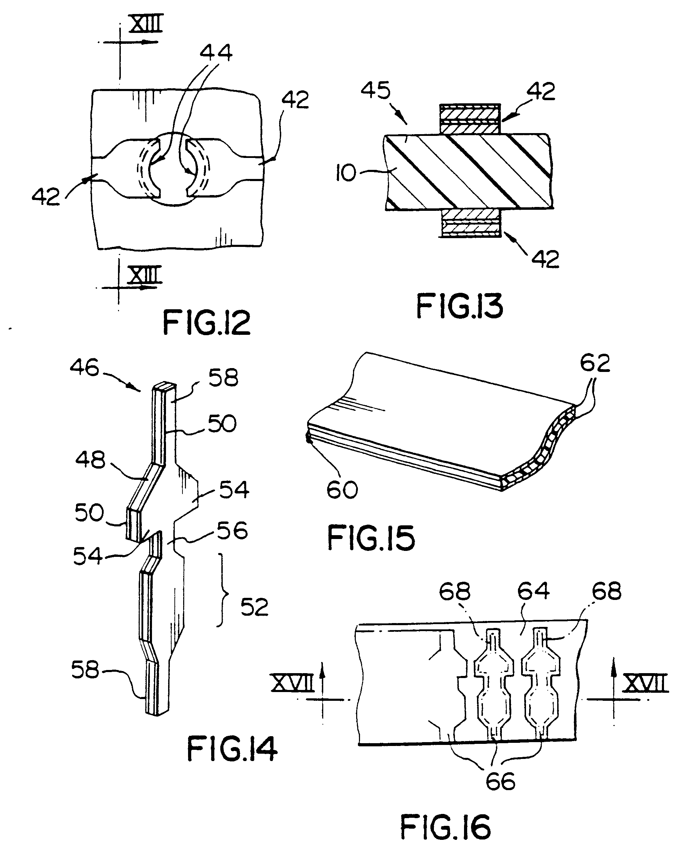

The masking plugs 22 are then removed from the holes 14 as shown in Figure 10. At this stage, as shown by a cross-section (Figure 11), the silk screen masking layers 18 overlie the electroless copper layer 16 at each side of each electroplated layer 32. The silk screen material is removed by conventional degreasing techniques to expose the underlying parts of the electroless deposited layer 16. By conventional etching techniques, all of the exposed copper is then removed. This comprises the electroless copper in the circumferentially extending regions 40 (Figure 10), which were previously masked by the plugs 22 and the layer 16 and the underlying originally provided copper layer 12 on each side of the substrate 10 which were covered by the silk screen 18. As a result, areas of the conductor material remain on both surfaces of the substrate (Figures 12 and 13) these desired areas providing individual circuit lines 42 on each side of the substrate 10 and which extend to individual electrical conductors 44 provided along the surface of each hole as shown by Figure 12. Conductors 44 extend circumferentially of each hole in arcuate fashion as shown in Figure 12 with each conductor composed of all of its layers 16, 30 and 36 to provide the total thickness of each conductor. With each hole thus bearing two separate conductors 44 and individual circuit lines 42 of the completed circuit board, the printed circuit board 45 is thus complete.

The printed circuit board of the first embodiment may be provided with the two conductors 44 in the manner described with holes 14 having a diameter of around 0.040 inches.

Each of the electrical conductors 44 may be employed as a through-hole connector merely for the purpose of providing two circuit connections from one side of the board to the other. The arcuate shape of each of the electrical conductors 44 and its thickness provide sufficient cross-sectional area for its electrical requirements. Thus the method according to the first embodiment provides two through-hole conductors of arcuate configuration and disposed within a diameter of 0.040 inches.

Alternatively, each hole 14 may be formed for receiving the circuit board pin and each of the conductors 44 is provided as a terminal for the circuit lines 42 on each side of the board to a circuit board pin provided with two conductor lines.

As shown by Figure 14, each circuit board pin 46 has a planar dielectric body 48 formed from a suitable plastics material, the dielectric body being of constant thickness from one end to the other of the pin at any section along the pin, the body 48 also being of rectangular or square section. Upon remote oppositely facing sides of the body 48 are provided two conductor lines 50 which completely cover the sides and are electrically isolated from one another by the body 48. The pin 46 has a main longitudinally extending section 52 for location within a hole 14 in the printed circuit board, two oppositely facing abutment shoulders 54 spaced from one end of the section 52 by a neck 56, and two ends 58 of the pin by which the two conductor lines 50 may be soldered or otherwise connected to separate incoming wiring or contact springs.

The pin 46 may be conveniently formed as one of a plurality of identically shaped pins by taking an indefinite length or strip 60 of the dielectrical material to form the body (see Figure 15) and after coating over the whole or both sides of the strip 60 with layers 62 of the conductive material, the individual pins are separated from the coated strip to provide the structure shown in Figure 14. The pins are separated in known manner for making conventional metal printed circuit board pins from strip by a stamping process.

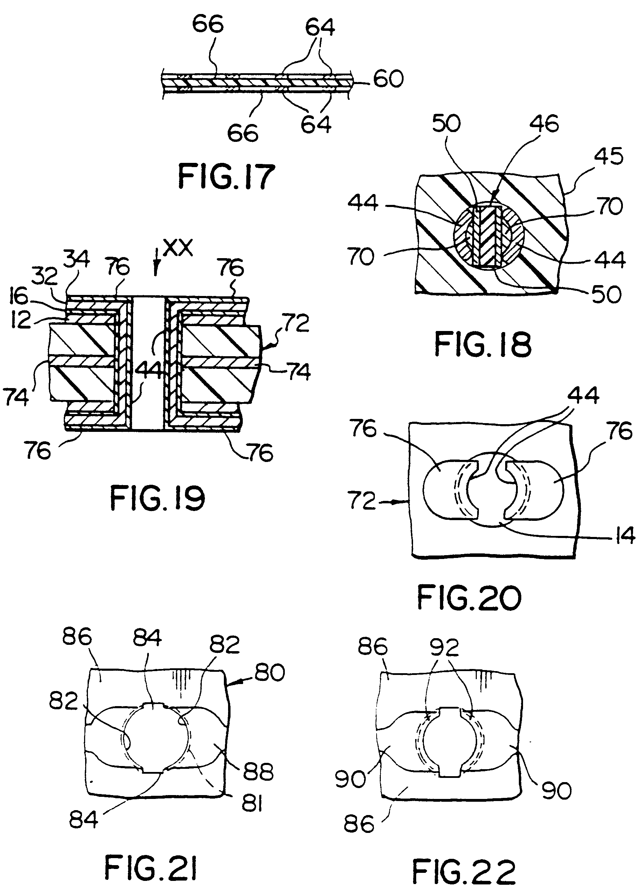

In an alternative method of forming each of the pins 46 (Figures 16 and 17), the strip 60 is selectively masked on regions 64 on each side of the strip so as to provide unmasked regions 66 which correspond to and extend slightly outside of the pins to be stamped as indicated by the chain-dotted lines 68 for the pins in Figure 16. The strip is then selectively plated in the unmasked regions 66 on both sides of the strip. The pins are separated from the strip and again have the structure of figure 14.

A plurality of the pins 46 are inserted, each into an individual hole 14, in the printed circuit board 45. With regard to each hole as shown in Figure 18, the pin 46 extends diametrically across the hole and each of the conductor lines 50 electrically contacts two axially extending edges of a respective terminal provided by a conductor 44 lying within the hole. In fact, corners at the edges of the conductors 44 may cut into the conductor lines 50 during assembly so as to provide a gas-tight effective connection. Subsequently, gaps defined between the conductors 44 and the conductor lines 50 are filled with solder 70 so as to secure the pin 46 in position and also to provide an effective and permanent electrical connection between each conductor line 50 and its conductor terminal 44 within the hole. Each conductor line 50 is thus electrically connected with an individual circuit line 42 on each side of the board. The soldering operation may be performed by known soldering techniques, e.g. by the use of vapor phase soldering techniques together with a solder doughnut disposed upon an upper end of the pin and which is caused to flow along the gaps upon melting of the solder. It has been found that with the use of solder, with each electrical conductor 44 connected securely to its conductor line 50, no electrical connection is formed by the solder around the body 48 between one conductor line 50 and the other.

With the pin 46 described above, the dimension along the major axis across the section 52 may be suitable for insertion into a 0.040 inch diameter hole and is comparable to dimensions of conventional all metallic circuit board pins. While the dimensions are comparable, the pin 46 does provide two completely electrically isolated conductor lines 50. The plastics material of the body provides the required strength for the body for handling and pin insertion purposes while the conductor lines 50 need only have sufficient cross-sectional area for their electrical requirements. The thickness of each of the conductor lines 50 may only be in the region of 0.005 inches. Thus there is a small cross-sectional area of conductor line 50 on each side of the body 48 and, as a result, a minimised resistance to the passage of electrical signals along the conductor lines.

With the two conductors 44 provided at each hole in the board for connection to an individual pin 46 or alternatively for use as through-hole conductors, an extremely dense circuitry arrangement may be provided with the electrical conductors at each hole being disposed extremely closely together and with each hole diameter being sufficiently small to accommodate one of the pins 46. For a required circuitry arrangement, the size of the printed circuit board is accordingly minimised.

When the conductors 44 are to be used as through-hole conductors, masking plugs may be caused to remain in each of the holes. However, these plugs need to be of different design from the plugs 22 in that they must be contained wholly within each of the holes 14 so as not to extend outwardly beyond the conductive material on each side of the board.

In a modification of the pins 16, the body 18 may be formed of other dielectric material such as fibreglass or a ceramic.

In a modification of the first embodiment as shown in Figure 19 and 20, a printed circuit board 72 is provided with two electrical conductors 44 within each of its holes 40 as described in the first embodiment. However, the board 72 is provided with two individual circuit lines 74 extending to each of the holes 14 in the board. Each of the circuit lines 74 is electrically connected, one to each of the electrical conductors 44. In this modification, the electrical conductors 44 serve the sole function of providing terminals for pins similar to the pins 46 described in the first embodiment and therefore outside circuit line connections upon the board and to the conductors 44 are not required. In this case the silk screen masking arrangement on each surface of the board has resulted in removal of sufficient copper material to result in two terminal pads 76 (Figure 20) each forming an extension of its associated terminal 44. As shown by Figure 19, each of the terminal pads 76 is composed of the layers 12, 16 and 32 of copper material together with the tin/lead layer 34, each layer being provided in the manner described in the first embodiment.

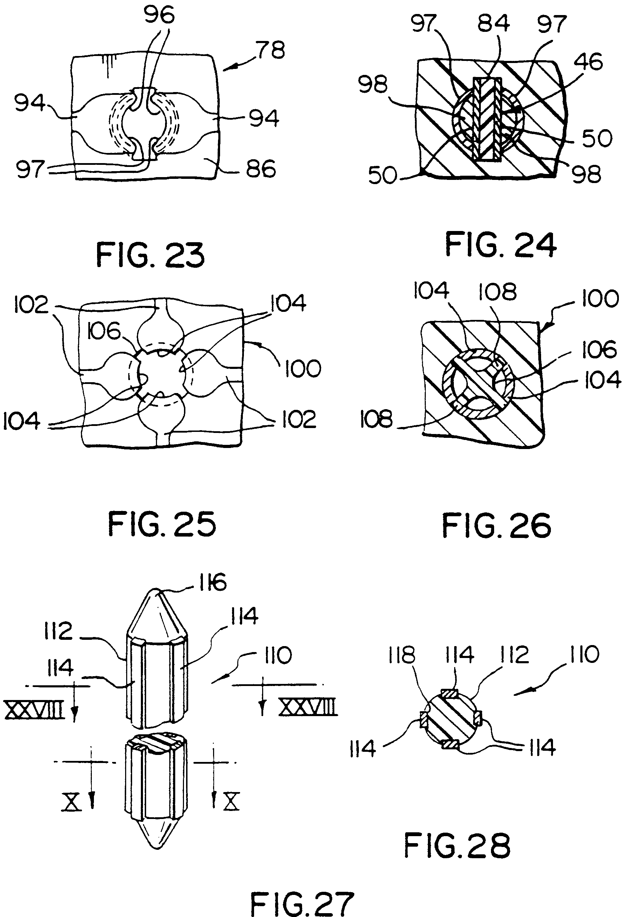

In a second embodiment as shown by Figures 21, 22 and 23, printed circuit board 78 (Figures 23) is formed from a substrate 80 (Figure 21) having upon each side surface a preformed layer (not shown) of copper as described in the first embodiment. After a layer of copper is laid over all surfaces by an electroless process and provides an extra thickness layer 82 of 0.0001 to 0.0002 inches which extends around the inside surface of the hole in a similar manner to the layer 14 in the first embodiment, then diametrically opposed circumferentially extending regions 84 of the layer 82 are removed as shown by Figure 21. Regions 84 may extend also into the material of the substrate itself, but preferably should not do so, because of delamination problems which may result in the fibreglass of the substrate. However, to distinguish in the drawings, the process of this embodiment from the first embodiment, the regions 84 are, indeed, shown as extending into the substrate although in practice this is not advisable. The material at the regions 84 may be removed by milling, routing, broaching or laser cutting techniques. The removed regions 84 are of such a size as to comfortably accept a section 52 of a pin 46 when the pin is pressed into the hole as shown in Figure 24. The copper on the two surfaces of the board is then covered in regions where copper conductors are not required in the finished board by a silk screen layer 86 as shown in Figure 21 so that copper remains exposed upon each surface in regions 88 where circuit lines are to be provided to each of the holes 81. Subsequently, as shown in Figure 22, a further conductive layer 90 is applied by electroplating upon the regions 88 and a layer 92 of copper is also applied by electroplating upon the electroless layer 82. A section through the board with the respective layers then resembles that of Figure 7 in the first embodiment with the masking plug in Figure 7 omitted. A final deposition is then made with an etch masking material, i.e. tin/lead, to provide an overlying layer 94 (Figure 23) upon the layer 90 and a layer 96 of tin-/lead is formed upon the layers 92 within the hole. A section through the board 80 at this stage then resembles Figure 9 in the first embodiment with the masking plug 22 removed. The silk screen layer 86 is then removed from each side of the board and the copper material underlying the silk screen is then removed by conventional etching techniques. This results in circuit lines on the board surfaces underlying and including the layers 94, and arcuate electrical conductors 97 within each hole extending circumferentially around the hole and spaced apart from each other. Each of the conductors 97 is formed from the preformed copper layer and the electroless layer together with the layers 92 and 96 in the manner described above.

With each conductor 97 acting as a terminal within its respective hole (Figure 24), a pin 46 is inserted into each hole and extends diametrically across it and into the two removed regions 84 with each conductor line 50 electrically abutting edges of a respective conductor 97. In Figure 24 each conductor terminal 97 is sectioned as a single layer for clarity. Subsequently gaps formed between the conductor terminals 97 and the conductor lines 50 are filled with solder 98 so as to secure each pin in position and also to provide an effective electrical contact between each conductor line 50 and its respective conductor terminal 97. The soldering operation may be performed by known soldering techniques as explained in the first embodiment.

In further embodiments now to be described, while more than two electrical conductors are described within each hole of a printed circuit board, the size of each hole and its respective circuit board pin for use with the hole, may, because of manufacturing restrictions need to be larger than those described in the first and second embodiments.

In Figure 25, there is shown a plan view of a printed circuit board 100 having four individual circuit lines 102 on each side (one side only being shown) of the board. Each circuit is integral with an electrical conductor 104 which extends along each hole on the surface thereof. Each electrical conductor extends circumferentially of the hole as shown in Figure 25 and is electrically isolated by being circumferentially spaced from adjacent electrical conductors.

While the steps in the manufacture of the board 100 may be similar to those described in the first embodiment by using masking plugs to mask parts of each hole upon which electrical conductors are not required, clearly the plugs 106 themselves, as shown by Figure 26, are of different shape from the plugs 22 described in the first embodiment. As shown by Figure 26, each plug is substantially cruciform in cross-section with arms 108 providing the masked regions of the hole surface and upon which copper material should not be deposited. Figure 26 does not shown the detail of the layers of each of the conductors 104 as is shown in previous embodiments, but it should be understood that each conductor 104 is composed of an underlying copper layer which has been electrolessly deposited, an overlayer of electroplated copper material.

This is the composition of each conductor 104 in the stage at Figure 26 with the mask in position. Subsequently, a tin/lead layer would also be applied to cover the electroplated layer prior to removal of the plugs 106 and masking material present upon the two sides of the board. Etching would then follow to remove the unwanted copper material within the holes and upon the surfaces of the board substrate.

A printed circuit board pin 110 for use with the printed circuit board 100 of the third embodiment is of definite length as shown by Figure 27 and comprises a dielectric body 112 which carries four relatively electrically isolated conductor lines 114 extending along the length of the body. These are clearly shown in Figures 27 and 28. The body is molded from a urethane material or from any other suitable dielectric material, and has tapered ends 116. The conductor lines 114 are of substantially rectangular shape as shown in Figure 28 and are laterally spaced-apart around the substantially circular periphery of the body and lie in recesses 118 of the body so as to protrude slightly from the surface of the body.

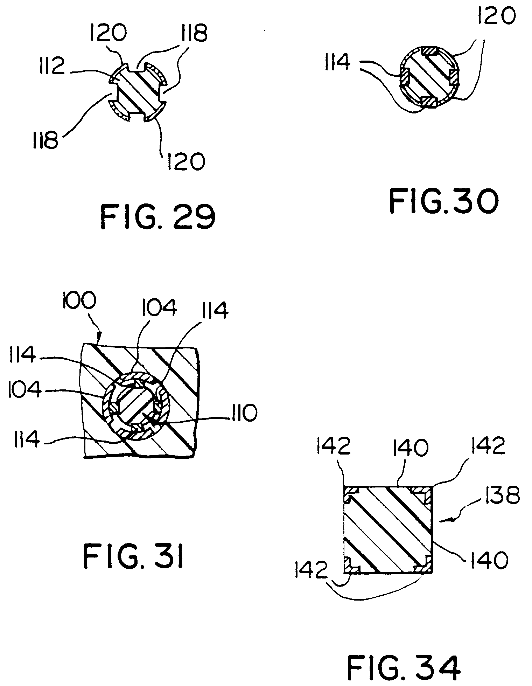

The conductor lines 114 may be formed by a plating process, the stages of which are shown in Figures 29 and 30. After the body 112 has been preformed by molding techniques, which also provide the longitudinally extending recesses 118, the peripheral surface of the body is masked by the use of a suitable masking material 120 between the recesses 118. This is shown in Figure 29. After masking, the conductor lines 114 (Figure 30) are built-up within the recesses 118 by conventional plating techniques from copper and to the required depth. After removal of the masking material the cross-sectional shape of the pin is as shown in Figure 28.

Each of the pins 110 is inserted into its individual hole 106 in the printed circuit board. When inserted into position, the conductor lines 114 engage the conductor terminals 104, one to each conductor as shown by Figure 31. The conductor lines 114 may be soldered to their respective terminal conductors 104 by the use of a doughnut of solder, as in the first embodiment together with vapor phase soldering techniques. Alternatively, the plastic of the body 112 of each pin may have a certain compressive resiliency to allow for an interference compliant fit within its hole with each conductor line 114 in gas-tight engagement with its respective terminal conductor 104.

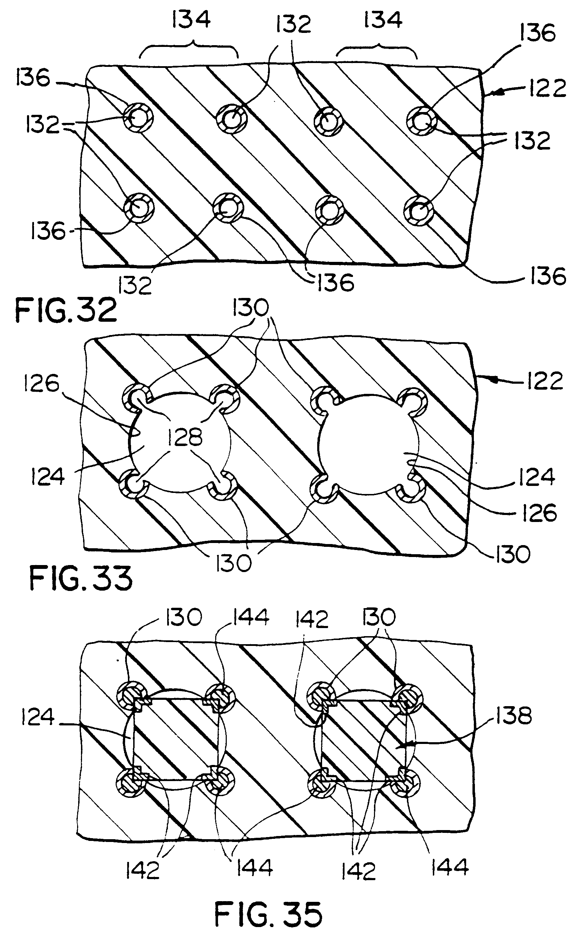

In a fourth embodiment as shown in Figure 33, a printed circuit board 122 comprises a plurality of pin receiving holes 124. Each pin receiving hole 124 has a main hole portion 126 of large diameter to accept a pin and a plurality, namely four, secondary hole portions 128 of substantially smaller diameter which are interconnected radially with the main hole portion 126 along the length of the hole. Each secondary hole portion 128 has upon its surface a conductor terminal 130. As may be seen from Figure 33, each conductor terminal 130 has ends at positions of intersection of the secondary hole portion with the main hole portion, the ends exposed at the circumference of the main hole portion.

Each hole 124 is formed initially by providing four secondary holes 132 as a group 134 with the holes spaced apart at the corners of an imaginary square around the axis of the hole 124 to be provided. Continuous composite conductive layers 136 composed of a first layer of electrolessly deposited copper and then a second copper layer by electroplating are then formed so as to completely cover the surfaces of the holes 132. An onerlaying tin/lead layer is also provided to protect the underlying layers during etching when certain conductive material on the outer surfaces of the board is removed (as described in other eubodiments) to provide individual circuit lines to each conductor 136. This is the situation shown in Figure 32. Subsequently, the main part 126 of the hole 124 is formed, the periphery of the main part 126 interesting the peripheries of the holes 132 so as to cause interconnection between the main and secondary hole portions as described above. During formation of the main hole part 126, a circumferentially extending section of each of the conductors 136 is removed to produce the conductor terminals 130 with terminal ends exposed at the circumference of the major hole portion 126 as has already been described.

Figure 34 illustrates a circuit board pin 138 for insertion into each of the holes 124. As is shown by Figure 34, the circuit board pin 138 is of square or rectangular section and has longitudinally flat sides 140. Junction regions between the sides 140 are recessed to accommodate conductor lines 142 which extend longitudinally of the pin. These conductor lines are substantially L- shaped with two legs of each line lying in a recess of the plane of the adjacent side 140. The lines 142 are conveniently formed by plating technigues similar to that described with reference to Figure 28 and 30.

As may be seen from Figure 35 a circuit board pin 138 is inserted into each of the holes 124. When each pin has been forced into position, each conductive line 142 is in gas seal-tight engagement with the two axially extending ends of corresponding conductor terminals 130 which are exposed at the circumference of the main portion 126 of the hole. Gaps between surfaces of the conductor lines 142 and the conductor terminals 130 are then filled with solder 144 by conventional soldering operations. The solder provides acceptable electrical continuity between the conductor lines 142 and the conductor terminals 130. As discussed above in previous embodiments, with the soldering operation, the solder is not caused to flow around the pin so that there is no electrical bridging between one conductor terminal 130 and the next.

As may be seen from the above embodiments, the invention is concerned with a printed circuit board having two or more electrical conductors associated with each hole and which serve individual circuit lines extending towards the hole. While the embodiments described illustrate the use of two or four such electrical conductors, in other embodiments there may be different numbers of conductors provided at each hole, for instance three or five conductors or more. The number of conductors which may be provided for each hole is subject to the practicalities of commercial manufacture involved in the provision of the numbers of conductors for each hole, the numbers of circuit lines which it is practically possible to extend to each hole, and the resultant minimum size of each hole capable of being provided with the required number of conductors.

## Claims

1. A printed circuit board comprising:-
   a substrate defining a plurality of holes and at least two electrical conductors provided upon the surface of each hole, the electrical conductors being spaced apart from one another circumferentially of each hole so as to be electrically isolated from one another with each conductor electrically connected to an individual circuit line carried by the substrate and extending towards the hole.

2. A printed circuit board according to claim 1, characterised in that, in at least some of the holes, each electrical conductor extends as an arcuate layer around the surface of its associated hole.

3. A printed circuit board according to claim 1 or 2 characterised in that, in at least some of the holes, the space within each hole unoccupied by electrical conductors is at least partially blocked by a plug of dielectric material, and the electrical conductors electrically connect an individual circuit line at one level of the board with another individual circuit line at another level of the board.

4. A printed circuit board according to claim 1, 2 or 3 characterised in that, in respect of each hole, each electrical conductor has a conductive underlayer formed by an electrolessly deposited conductor and a further layer of electroplated conductor covering the layer.

5. A printed circuit board according to claim 4, characterised in that an individual electrical conductor within at least one hole is electrically connected to an individual circuit line carried upon one side of the substrate, the circuit line comprising a conductor underlayer laminated to the substrate, a second layer or conductor overlaying the underlayer, the second layer formed by electrolesa deposition, and a third layer overlying the second layer, the third layer formed by electroplating.

6. A printed circuit board according to claim 1 characterised in that each hole is defined by a main hole portion and a plurality of secondary hole portions disposed in spaced positions around the main hole portion, the periphery of the main hole portion intersecting the peripheries of the secondary hole portions so that the main hole portion is interconnected with the secondary hole portions, and that an electrical conductor is disposed upon the surface of each secondary hole portion, the electrical conductor extending arcuately around the secondary hole portion and having ends at the positions of intersections of the secondary hole portion and the main hole portion, said ends exposed at the circumference of the main hole portion.

7. A method of providing a circuit board with electrical conductors within holes in a substrate of a board comprising:-

providing the substrate with a plurality of holes; and then forming at least two electrical conductors upon the surface of each hole, said electrical conductors spaced apart from one another circumferentially of each hole so as to be electrically isolated from one another.

8. A method according to claim 7 comprising forming the electrical conductors for each hole by:-

fitting a masking plug into each hole, the plug formed with axially extending recesses to leave desired exposed spaced circumferentially extending surface regions of the hole;

and providing conductor material on the spaced exposed circumferentially extending surface regions, the conductor material providing an electrical conductor upon each exposed surface region.

9. A method according to claim 7 comprising:-

applying conductive material to cover the whole surface of each hole;

inserting a masking plug into each hole to leave desired exposed spaced circumferential extending regions of the conductive material while masking other circumferentially extending regions of the conductive material;

coating the exposed regions of the conductor material with an etch resistant electrically conductive substance;

removing the plug;

and by etching, removing the uncoated conductor material at the previously masked regions whereby the desired regions of conductive material together with their coated substance provide the circumferentially extending electrical conductors.

10. A method according to claim 7 comprising:-

by an electroless plating method, providing a first layer of a conductive material to cover the surface of each hole;

inserting the masking plug into each hole to leave desired exposed and spaced circumferentially extending regions of the first layer of the conductive material while masking other circumferentially extending regions of the first layer;

by an electroplating method, applying a second layer of the conductive material to the exposed regions of the first layer of the conductive material so as to provide thicker exposed regions of the conductive material;

coating the thicker exposed regions of the conductive material with an etch resistant electrically conductive substance;

removing the plug;

and etching the uncoated first layer of conductive material at the previously masked regions so as to remove those regions whereby the thicker regions of the conductive layer together with their coating substance provide the circumferentially extending electrical conductors.

11. A method according to claim 7 comprising:-

providing an electroless plated layer of a conductive material upon the substrate which has been previously provided on at least one surface with a conductive layer, the electroless plated layer covering the surface of each hole and the previously provided conductive layer;

screening surface areas of the electroless plated layer on the previously provided conductive layer to result in desired unscreened areas of the electroless plated layer in which conductor is required on the surface of the completed circuit board;

inserting a masking plug into each hole to leave desired exposed and spaced circumferentially extending regions of the electroless plated layer within the hole while masking other circumferentially extending regions of the electroless plated layer within the hole;

providing an electroplated layer to the exposed regions of the electroless plated layer within the hole thereby providing thicker exposed regions of the conductive material within each hole, the electroplated layer also covering the unscreened areas of the electroless plated layer on the surface of the substrate to provide thicker unscreened areas;

coating the thicker exposed regions and thicker unscreened areas of the conductive material with an etch resistant electrically conductive substance;

removing the plug and the screen;

and etching away the conductive material and the previously provided conductive layer unprotected by the coating of etch resistant substance whereby thicker regions and thicker areas of conductive material together with their coating substance provide the circumferentially extending electrical conductors within the holes and the desired areas of conductor on the surface of the board.

12. A method according to claim 7 comprising completely covering the surface of each hole with a layer of conductor material and then selectively removing the conductive material at spaced circumferential positions to provide at least two circumferentially extending electrically isolated terminal layers which are spaced apart around the hole.

13. A method according to claim 12 comprising:-
by an electroless plating method, providing a first layer of a conductive material to cover the surface of each hole;
removing arcuate circumferentially extending regions of the conductive material to leave desired spaced circumferentially extending regions of the conductive material in each hole;
and by an electroplating method, applying the second layer of the conductive material to the first layer in the desired spaced regions.

14. A method according to claim 7 comprising:-
providing an electroless plated layer of a conductive material upon the substrate which has been previously provided on at least one surface with a conductive layer, the electroless plated layer covering the surface of each hole and the previously provided conductive layer;
removing arcuate circumferentially extending regions of the conductive material to leave desired spaced circumferentially extending regions of conductive material in each hole;
screening surface areas of the electroless plated layer on the previously provided conductive layer to result in desired unscreened areas of the electroleas plated layer in which conductor is required on the surface of the completed circuit board;
providing an electroplated layer to the desired spaced regions within each hole thereby providing thicker desired exposed regions of conductive material within each hole, the electroplated layer also covering the unscreened areas of the electroless plated layer on the surface of the substrate to provide thicker unscreened areas;
coating the thicker exposed regions and unscreened areas of the electroplated layer with an etch resistant electrically conductive substance;
removing the screen;
and etching away the conductive material and the previously provided conductive layer unprotected by the coating of etch resistant substance whereby the thicker regions and areas together with their coating substance provide the circumferentially extending electrical conductors within the holes and the desired areas of conductors on the surface of the board.

15. A method according to claim 7 comprising forming each hole and providing its conductors by:-
forming a plurality of secondary holes in spaced positions around a desired axis for the hole which is to be completed;
providing a layer of conductor material upon the surface of each secondary hole;
and then forming a main portion of the hole along the desired axis, the main portion of the hole intersecting the peripheries of the secondary holes and removing a circumferentially extending section of the layer of conductive material in each secondary hole so as to form the completed hole with the main hole portion interconnected with secondary hole portions spaced circumferentially around the main hole portion and with each layer of conductive material providing a terminal layer which has ends at positions of intersection with the main hole portion, said ends exposed at the circumference of the main hole portion.

16. An assembly of a printed circuit board and a plurality of pins wherein the circuit board defines a plurality of holes and at least two electrical conductors are provided upon the surface of each hole, the conductors being spaced apart from one another circumferentially of each hole so as to be electrically isolated from one another with each conductor extending to an individual circuit path of the board which extends towards the hole, and each circuit board pin has a plurality of electrical conductor lines which extend longitudinally of the pin and are electrically isolated from one another, the pins inserted into individual holes with the circuit lines in electrical contact with individual electrical conductors within the holes.

FIG.1

FIG.2

FIG.3

FIG.4

FIG.5

FIG.6

FIG.7

FIG.8

FIG.9

FIG.10

FIG.11

XIII

44

42

42

**FIG.12**

45

10

42

42

**FIG.13**

46

58

50

48

54

50

56

54

52

58

**FIG.14**

62

60

**FIG.15**

68   64   68

XVII

XVII

66

**FIG.16**

FIG.17

FIG.18

FIG.19

FIG.20

FIG.21

FIG.22

**FIG. 23**

**FIG. 24**

**FIG. 25**

**FIG. 26**

**FIG. 27**

**FIG. 28**

FIG. 29

FIG.30

FIG. 31

FIG. 34

FIG. 32

FIG. 33

FIG. 35